# EUROPEAN PATENT APPLICATION

(11) **EP 4 645 203 A1**
(43) Date of publication of application: **05.11.2025**
(21) Application number: 23911305.3
(22) Date of filing: 27.09.2023
(51) Int. Cl.: G06Q 50/10, G01R 31/392, H01M 10/42, H01M 10/48, H02J 7/00, H02J 13/00

(54) **BATTERY MANAGEMENT PROGRAM AND BATTERY MANAGEMENT SYSTEM**

(30) Priority: 26.12.2022 JP 2022208198
(71) Applicant: DENSO CORPORATION, Kariya-city, Aichi-pref., 448-8661 (JP)
(72) Inventor: MIZUNO Yuki, Kariya-city, Aichi-pref., 448-8661 (JP); YAMAMOTO Nobuo, Kariya-city, Aichi-pref., 448-8661 (JP); KUSANO Yoshikazu, Kariya-city, Aichi-pref., 448-8661 (JP)
(74) Representative: Winter, Brandl - Partnerschaft mbB
(86) International application number: PCT/JP2023/035264
(87) International publication number: WO 2024/142521

(57) **Abstract**

The battery management program (P1) is configured to cause a processor (1) to implement a function of acquiring SOH information (S) based on battery monitoring data (X) of a battery (2) and a function of calculating the CO₂ emission amount (Ea), which is an environmental load factor related to the battery (2), based on the SOH information (S) as acquired. The battery management system (100) includes a battery management server (13) configured to acquire SOH information (S) based on battery monitoring data (X) of a battery (2), an emission calculation unit (121) configured to calculate CO₂ emission amount (Ea) based on the SOH information (S) acquired by the battery management server (13), and a CO₂ emission information display unit (125) configured to display emission information related to the CO₂ emission amount (Ea) calculated by the emission calculation unit (121).

## Description

### CROSS REFERENCE TO RELATED APPLICATION

The present application is based on Japanese Patent Application No. 2022-208198 filed on December 26, 2022. The entire disclosures of all of the above applications are incorporated herein by reference.

### TECHNICAL FIELD

The present disclosure relates to a technique for managing batteries.

### BACKGROUND ART

Patent Literature 1 below discloses an information processing apparatus for calculating emission for an environmental load factor. This information processing apparatus includes an accounting data storage unit that stores information for identifying an asset and accounting data that associates a value of the asset, a coefficient storage unit that stores an emission coefficient of an environmental load substance for each asset, and an emission calculation unit that calculates emission of an environmental load substance for each asset by multiplying a value corresponding to the asset by the emission coefficient for each asset. This information processing apparatus enables to easily calculate the emission of the environmental load factor based on the accounting data and the emission coefficient.

### PRIOR ART LITERATURE

### PATENT LITERATURE

PATENT LITERATURE 1: JP-7043691B

### SUMMARY OF INVENTION

In recent years, with the increasing awareness of environmental issues, there has been a growing need to grasp an environmental impact of a battery used in a vehicle such as an electric vehicle and a hybrid vehicle, as well as in a consumer and industrial device. It is known that this type of battery is involved in emission of greenhouse gas such as carbon dioxide, which is one of the environmental load factors, at various stages including manufacturing, usage, repair, and replacement.

In the information processing apparatus of Patent Literature 1, the emission of environmental load factors are calculated based on the accounting data for a fixed asset and the emission coefficient. Therefore, there is a concern that the calculated emission might diverge from the actual emission.

It is an abject of the present disclosure to provide an effective battery management technique for accurately determining emission of an environmental load factor associated with a battery.

According to an aspect of the present disclosure, a battery management program is configured to cause a processor to implement: a function of acquiring SOH information based on battery monitoring data of a battery; and a function of calculating an emission amount of an environmental load factor related to the battery based on the SOH information as acquired.

According to another aspect of the present disclosure, a battery management system comprises: an SOH information acquisition unit configured to acquire SOH information based on battery monitoring data of a battery; an emission calculation unit configured to calculate an emission amount of an environmental load factor related to the battery based on the SOH information acquired by the SOH information acquisition unit; and a display unit configured to display environmental load factor emission amount information related to the emission amount calculated by the emission calculation unit.

According to the above-described aspects, it is possible to provide an effective battery management technique for accurately determining the emission of the environmental load factor associated with the battery.

It should be noted that the reference signs in parentheses in the claims are intended to indicate the correspondence with specific elements described in the embodiments described later and do not limit the technical scope of the present disclosure.

### BRIEF DESCRIPTION OF THE DRAWINGS

The above-described objects, as well as other objects, features, and advantages of the present disclosure, will become more apparent from the following detailed description, taken in conjunction with the accompanying drawings. The drawings are:
FIG. 1 is a block diagram showing a configuration of a battery management system according to a first embodiment;
FIG. 2 is a flowchart illustrating control implemented in a battery management unit shown in FIG. 1;
FIG. 3 is a flowchart illustrating the control implemented in a battery management server shown in FIG. 1;
FIG. 4 is a schematic diagram showing an example of a display content on a display device shown in FIG. 1;
FIG. 5 is a block diagram showing a configuration of a battery management system according to a second embodiment;
FIG. 6 is a flowchart illustrating control implemented in a battery management unit shown in FIG. 5;
FIG. 7 is a flowchart illustrating control implemented in a battery management server shown in FIG. 5;
FIG. 8 is a block diagram showing a configuration of a battery management system according to a third embodiment; and
FIG. 9 is a block diagram showing a configuration of a battery management system including a display program.

### DESCRIPTION OF EMBODIMENTS

Hereinafter, a battery management technique according to embodiments will be described in detail with reference to the drawings. This battery management technique generally involves calculating emission of an environmental load factor related to a battery based on actual data of the battery.

Greenhouse gas is considered as an environmental load factor. In this embodiment, as a battery management technique, a technique for calculating emission of carbon dioxide (hereinafter referred to as "CO₂"), which is one of the greenhouse gases, will be explained.

### (First Embodiment)

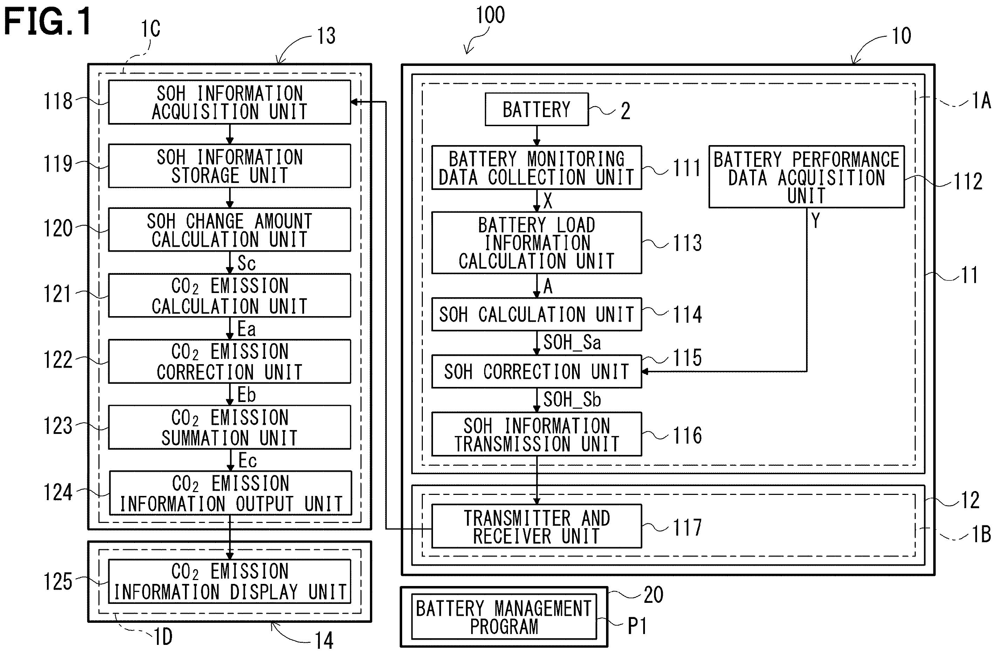

As shown in FIG. 1, a battery management system 100 of the first embodiment is a system for managing a battery 2 that includes a battery cell mounted on a vehicle 10 such as an electric vehicle or a hybrid vehicle. The battery management system 100 may also monitor the battery 2 installed in a consumer device or industrial equipment other than the vehicle 10. The function of the battery management system 100 is executed by the processor 1.

The term "processor 1" as used herein broadly includes a processing device responsible for an operation such as data computation and conversion, program execution, and control of other devices among components of a computer. The processor 1 includes a CPU (Central Processing Unit) that controls the entirety of the computer, or an MPU (Micro Processing Unit) that integrates functions of the CPU.

The battery 2 includes an assembled battery composed of a combination of multiple battery cells. The battery cells are secondary batteries, which are rechargeable and usable repeatedly. The battery 2, together with a battery management unit 11, forms a so-called "battery pack." The battery pack may be a replaceable (cartridge-type) unit that is removably mounted on the vehicle 10, or the battery pack may be a fixed unit that is non-removably mounted on the vehicle 10.

The battery management system 100 includes the battery management unit 11, an in-vehicle communication device 12, a battery management server 13, and a display device 14.

### 1. Configuration of Battery Management Unit 11

The battery management unit 11 is provided in the vehicle 10 and includes the following components: a battery monitoring data collection unit 111, a battery performance data acquisition unit 112, a battery load information calculation unit 113, an SOH (State of Health) calculation unit 114, an SOH correction unit 115, and an SOH information transmission unit 116. The functions of these components are executed by the first processor 1A. This first processor 1A, together with the second processor 1B, the third processor 1C, and the fourth processor 1D, which will be described later, is included in the processor 1.

The battery monitoring data collection unit 111 has a function of collecting battery monitoring data X from the battery 2. The "battery monitoring data X" described here may include, for example, time-series data such as a current and a voltage. The battery monitoring data collection unit 111 is equipped with sensors capable of detecting the battery monitoring data X to be collected (e.g., a current sensor, a voltage sensor, and a temperature sensor).

The battery performance data acquisition unit 112 has a function of measuring battery performance 1data Y of the battery 2. The "battery performance data Y" described here may include, for example, measurement data such as a capacity, a resistance, and an AC impedance. The "Measurement" refers to a process for acquiring the measurement data. A time required to measure the battery performance data Y exceeds a time required to collect the battery monitoring data X. Therefore, in order to reduce the time, it is preferable to minimize a frequency of measuring the battery performance data Y as much as possible.

The battery load information calculation unit 113 has a function of calculating the battery load information A of the battery 2 from the battery monitoring data X acquired by the battery performance data acquisition unit 112. In other words, the battery load information A is information acquired from the battery monitoring data X. Herein, the "battery load information A" may include, for example, usage history of the battery 2 indicated by a current, a voltage, a temperature, and the like, or the usage history of the battery 2 indicated by an SOC (State Of Charge) calculated based on these values of the usage history.

The SOH calculation unit 114 has a function of calculating the SOH (State Of Health) of the battery 2 based on battery load information A calculated by the battery load information calculation unit 113. A correlation between the battery load information A and the SOH may be established in several ways: creating the correlation in advance through machine learning by using a secondary battery for evaluation measurement; creating the correlation based on actual measurement conducting accelerated degradation test using a secondary battery for evaluation measurement; or creating the correlation by using a calculation formula that logically derives the correlation by using a model of the secondary battery. In other words, this degradation model formula indicates the correlation between the usage history of the battery 2 and the SOH.

The SOH correction unit 115 has a function of correcting the SOH calculated by the SOH calculation unit 114 based on the battery performance data Y acquired by the battery performance data acquisition unit 112, as needed. In the SOH correction unit 115, the correlation between the battery performance data Y and the SOH is stored. The form of this correlation is not particularly limited and may be in the form of a model, a calculation formula, a map, a graph, a table, or another format. The SOH correction unit 115 determines whether the SOH calculated from the degradation model formula needs correction, and when determining that the correction is necessary, it updates this SOH with the SOH calculated from the measurement model. According to this function, by calculating and updating the SOH from the measurement model, it is possible to acquire the SOH more accurately.

For convenience of explanation, the SOH before correction will be referred to as "SOH_Sa," and the SOH after correction will be referred to as "SOH_Sb." In this case, both the SOH_Sa and the SOH_Sb are SOH information S related to the SOH of the battery 2.

The necessity for the SOH correction may be determined, for example, by whether a continuous usage period of the battery 2 exceeds a threshold value (e.g., in months, years, or other units). In this case, it may be determined that correction is necessary on the condition that the continuous usage period of the battery 2 has exceeded the threshold value. Alternatively, for example, by comparing the SOH_Sa with the SOH_Sb, when the difference between the SOH_Sa and the SOH_Sb is greater than or equal to the threshold value, it may be determined that the SOH_Sa deviates from the actual value and requires the correction.

Herein, a specific example of the calculation method of the SOH_Sb based on the above measurement model will be explained. When using the capacity as the measurement data, a full charge capacity may be calculated by dividing a segment capacity of the battery 2 by ΔSOC, and the SOH_Sb may be estimated by dividing this full charge capacity by an initial capacity. Herein, "ΔSOC" refers to a change amount in the State Of Charge (SOC) of the battery 2, which represents a depth of discharge and charge. The correlation between the battery performance data Y and the SOH may be created in advance using machine learning with a secondary battery for evaluation measurement, based on actual measurement acquired through accelerated degradation test using the secondary battery for evaluation measurement, or by using a model of a secondary battery to derive a logical correlation through a calculation formula.

The SOH information transmission unit 116 has a function of transmitting SOH information S (SOH_Sa or SOH_Sb) to the in-vehicle communication device 12.

The battery management unit 11 may include only a first configuration group, which includes the battery monitoring data collection unit 111, the battery load information calculation unit 113, the SOH calculation unit 114, and the SOH information transmission unit 116. Alternatively, the battery management unit 11 may include only a second configuration group, which includes the battery performance data acquisition unit 112, the SOH correction unit 115, and the SOH information transmission unit 116. The battery management unit 11 may also include both the first configuration group and the second configuration group.

### 2. Configuration of the In-Vehicle Communication Device 12

The in-vehicle communication device 12 is installed in the vehicle 10 and includes, as a component, a transmitter and receiver unit 117. The transmitter and receiver unit 117 has a function of receiving data (SOH information S) from the SOH information transmission unit 116 of the battery management unit 11 and transmitting the data to the battery management server 13. The functions of the transmitter and receiver unit 117 are executed by a second processor 1B installed in the in-vehicle communication device 12.

### 3. Configuration of the Battery Management Server 13

The battery management server 13 includes, as components, an SOH information acquisition unit 118, an SOH information storage unit 119, an SOH change amount calculation unit 120, a CO₂ emission calculation unit 121, a CO₂ emission correction unit 122, a CO₂ emission summation unit 123, and a CO₂ emission information output unit 124. Functions of these components are executed by a third processor 1C installed in the battery management server 13.

The SOH information acquisition unit 118 has a function of acquiring SOH information S via the transmitter and receiver unit 117. The SOH information storage unit 119 has a function of storing the SOH information S acquired by the SOH information acquisition unit 118. The SOH change amount calculation unit 120 has a function of reading the SOH information S (SOH_Sa or SOH_Sb) from the SOH information storage unit 119 and calculating the SOH change amount Sc per unit period. The "unit period" described here is not particularly limited and may be, for example, in units of seconds, minutes, hours, days, weeks, months, or years.

Herein, the SOH change amount Sc is a degree of degradation of the battery 2 per unit period, and similar to the SOH_Sa and the SOH_Sb, SOH change amount Sc is the SOH information S related to the SOH of the battery 2. Therefore, in this embodiment, the battery management server 13 has a function of an SOH information acquisition unit that acquires the SOH information S. In this regard, various modifications may be adopted in which the battery management server 13 performs at least the function of acquiring the SOH information S. For example, the SOH change amount Sc may be calculated by the battery management unit 11 and then acquired by the battery management server 13.

The CO₂ emission calculation unit 121 has a function of calculating a CO₂ emission amount Ea by multiplying the SOH change amount Sc calculated by the SOH change amount calculation unit 120 by a CO₂ emission coefficient. Herein, the CO₂ emission coefficient, also referred to as a CO₂ emission factor, means a total CO₂ emission value per functional unit. By using the SOH change amount Sc, it is possible to calculate the CO₂ emission amount Ea with high accuracy, taking into account the degradation state and individual differences of the battery 2.

When allocating the CO₂ emission during battery manufacturing with high accuracy using the SOH change amount Sc, the CO₂ emission coefficient related to the battery manufacturing may be set to a functional unit, such as battery capacity (Ah), a power capacity (Wh, kWh), a procurement cost (yen, ten thousand yen), a product weight (kg, ton), and the like. As a result, the CO₂ emission per battery capacity (kg-CO₂/Ah), the CO₂ emission per power capacity (kg-CO₂/Wh, kg-CO₂/kWh), the CO₂ emission per procurement cost (kg-CO₂/yen, kg-CO₂/ten thousand yen), and the CO₂ emission per product weight (kg-CO₂/kg, kg-CO₂/ton), and the like are calculated. At this time, it is preferable to set the CO₂ emission coefficient individually according to a product name, a product number, a manufacturing company, a manufacturing facility, a manufacturing line, and a manufacturing lot of the battery 2. The total CO₂ emission amount Ea may be calculated from the SOH change amount Sc, the functional unit, and the CO₂ emission coefficient. For example, the total CO₂ emission (kg-CO₂) may be calculated using the following formula: CO₂ total emission (kg-CO₂) = SOH change amount (%) × initial battery capacity (kWh) × CO₂ emission coefficient (kg-CO₂/kWh). Additionally, it is preferable that the CO₂ emission coefficient is individually set according to contribution of each situation that causes CO₂ emission (for example, during manufacturing, distribution, usage, and post-usage stages of the battery 2), or the CO₂ emission coefficient may be set as a single coefficient encompassing all these situations.

In a case where allocating the CO₂ emission during the battery distribution with high accuracy based on the SOH change amount Sc, by acquiring a distribution distance from a battery manufacturing factory, a battery retailer, or an electric vehicle manufacturing factory to an electric vehicle retailer, this distribution distance may be used as a functional unit for the calculation. For example, the total CO₂ emission (kg-CO₂) may be calculated using the following formula: CO₂ total emission (kg-CO₂) = SOH change amount (%) × distribution distance (km) × CO₂ emission coefficient (kg-CO₂/km).

When allocating the CO₂ emission during recovery of the battery after use with high accuracy based on the SOH change amount Sc, by acquiring a distribution distance from a usage site to a recovery and repair site, this distribution distance may be used as a functional unit for the calculation. For example, the total CO₂ emission (kg-CO₂) may be calculated using the following formula: CO₂ total emission (kg-CO₂) = SOH change amount (%) × distribution distance (km) × CO₂ emission coefficient (kg-CO₂/km).

The CO₂ emission coefficient described above may be acquired from a battery manufacturing company, an industry association, or a third-party certification organization. This CO₂ emission coefficient may be acquired based on information such as a product name, a product number, a manufacturer ID, and a manufacturer name of an item that is a calculation object.

The CO₂ emission correction unit 122 has a function of correcting the CO₂ emission amount Ea calculated by the CO₂ emission calculation unit 121 based on a correction result of the SOH by the SOH correction unit 115, as necessary. According to this function, a corrected emission amount Eb, which is a corrected value of the CO₂ emission amount Ea, is calculated. In this way, by using the corrected emission amount Eb, it becomes possible to update the CO₂ emission amount Ea to a more accurate value.

The CO₂ emission summation unit 123 has a function of summing multiple CO₂ emission amounts Ea calculated by the CO₂ emission calculation unit 121 and multiple CO₂ emission amounts Eb calculated by the CO₂ emission correction unit 122 (calculating a total emission amount Ec) according to a specified condition. The "specified condition" described here refers to, for example, a specified time unit (such as seconds, minutes, hours, days, weeks, months, years), a specified notification unit (such as per vehicle, per site, per business entity, per consignor), and the like. The total emission amount Ec may be calculated according to either the time unit or the notification unit, or may be calculated according to both the time unit and the notification unit. Additionally, the specified condition may be predetermined, or may be changeable within the system.

The CO₂ emission information output unit 124 has a function of outputting CO₂ emission information related to the CO₂ emission. The "CO₂ emission information" referred to here includes at least one of the CO₂ emission amount Ea calculated by the CO₂ emission calculation unit 121, the corrected emission amount Eb calculated by the CO₂ emission correction unit 122, and the total emission amount Ec calculated by the CO₂ emission summation unit 123.

The battery management server 13 may be provided with only a third configuration group including the SOH information acquisition unit 118, the SOH information storage unit 119, the SOH change amount calculation unit 120, the CO₂ emission calculation unit 121, the CO₂ emission summation unit 123, and the CO₂ emission information output unit 124. Alternatively, the battery management server 13 may be provided with only a fourth configuration group including the CO₂ emission correction unit 122, the CO₂ emission summation unit 123, and the CO₂ emission information output unit 124. The battery management server 13 may also be provided with both the third configuration group and the fourth configuration group.

### 4. Configuration of the Display Device 14

The display device 14 is equipped with a CO₂ emission information display unit 25. The CO₂ emission information display unit 125 has a function of receiving and displaying the CO₂ emission information (environmental impact factor emission information) output from the CO₂ emission information output unit 124 of the battery management server 13. The function of the CO₂ emission information display unit 125 is executed by a fourth processor 1D installed in the display device 14. The display device 14 is typically provided in various devices such as a desktop or notebook personal computer (PCs), a tablet device, and a mobile device.

The function of each component of the battery management system 100 is implemented by causing the processor 1 to execute a battery management program P1. Therefore, the battery management program P1 is a program that enables the processor 1 to implement the function of each component. This battery management program P1 is stored in a non-transitory storage medium 20. The non-transitory storage medium 20 is independently described in the drawings to avoid complexity in notation. However, the non-transitory storage medium 20 is included in the vehicle 10, the battery management server 13, and the display device 14. The non-transitory storage medium 20 included in each of these components stores at least a part of the battery management program P1. Various types such as a memory type, a disk type, and a tape type may be used as the non-transitory storage medium 20. The battery management program P1 may also be stored in a cloud server. At least a part of the battery management program P1 may be downloaded from the cloud server to the vehicle 10, the battery management server 13, and the display device 14.

The allocation of the multiple components (functional elements) of the battery management system 100 among the battery management unit 11, the in-vehicle communication device 12, the battery management server 13, and the display device 14 is not limited to the example shown in FIG. 1 and may be suitably modified as necessary. Additionally, another device and a facility (for example, a battery charging stand for charging the battery 2, a battery exchange station for exchanging the battery 2, a battery service center for repairing or replacing the battery 2, and the like) may also be used as an allocation destination for the components (functional elements).

### 5. Control of the Battery Management System 100

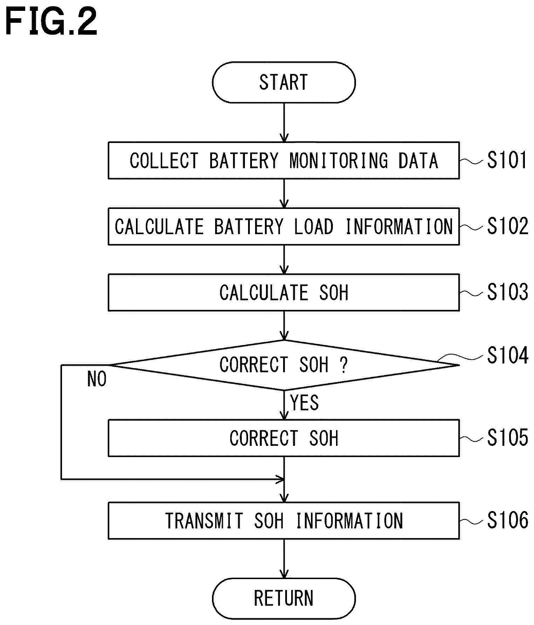

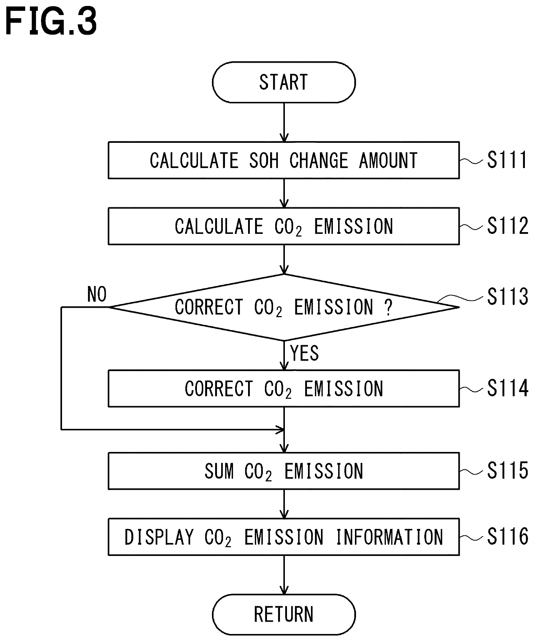

Next, a control by the battery management system 100 will be described with reference to FIGS. 1 to 3. FIG. 2 shows a control flowchart of the battery management unit 11 in the battery management system 100, and FIG. 3 shows a control flowchart of the battery management server 13 in the battery management system 100.

As shown in FIG. 2, in the battery management unit 11 (see FIG. 1) of this embodiment, steps from step S101 to step S106 are sequentially executed. It should be noted that one or more steps may be added to these steps as necessary, or multiple steps may be appropriately integrated.

Step S101 is a step where the above-described battery monitoring data X is continuously collected by the battery monitoring data collection unit 111. Step S102 is a step where the battery load information A is calculated from the battery monitoring data X collected in step S101 by the battery load information calculation unit 113. Step S103 is a step where the SOH_Sa of the battery 2 is calculated by the SOH calculation unit 114 from the battery load information A calculated in step S102.

Step S104 is a step where it is determined whether to correct the SOH_Sa calculated in step S103. When it is determined in step S104 that the SOH_Sa should be corrected (in the case of "Yes" in step S104), the process proceeds to step S106 via step S105. On the other hand, when it is determined in step S104 that the SOH_Sa is not to be corrected (in the case of "No" in step S104), the process skips step S105 and proceeds directly to step S106.

Step S105 is a step where the SOH_Sa is corrected by the SOH correction unit 115 based on the above-described battery performance data Y acquired by the battery performance data acquisition unit 112. According to step S105, the SOH_Sa is updated to the corrected SOH_Sb. Step S106 is a step where the SOH information S (either SOH_Sa or SOH_Sb) is transmitted by the SOH information transmission unit 116. This SOH information S is stored in the SOH information storage unit 119 via the transmitter and receiver unit 117 and the SOH information acquisition unit 118.

It should be noted that the process of calculating the SOH_Sa based on the battery monitoring data X and the process of calculating the SOH_Sb based on the battery performance data Y may be executed consecutively or independently of each other.

Herein, the advantages of correcting the SOH_Sa in step S105 are as follows. That is, since the SOH_Sa is calculated based only on the battery monitoring data X, there may be an instance where the SOH_Sa is calculated as a value deviating from the actual value due to continued use of the battery 2. On the other hand, while the value of the SOH_Sb calculated based on the battery performance data Y is highly accurate, the SOH_Sb takes more time to acquire compared to the battery monitoring data X. Therefore, it is preferable to calculate the SOH_Sa based solely on the battery monitoring data X at all times, and calculate the SOH_Sb as needed to update the SOH_Sa. By doing so, it is possible to derive an accurate value of the SOH of the battery 2 while minimizing a processing time required to derive the SOH of the battery 2.

As shown in FIG. 3, in the battery management server 13 of this embodiment (see FIG. 1), steps from step S111 to step S116 are sequentially executed. It should be noted that one or more steps may be added to these steps as necessary, or multiple steps may be appropriately integrated.

Step S111 is a step where the SOH change amount Sc per unit period is calculated by the SOH change amount calculation unit 120 from multiple items of SOH information S stored in the SOH information storage unit 119. Step S112 is a step where the CO₂ emission amount Ea is calculated by multiplying the CO₂ emission coefficient described above by the SOH change amount Sc calculated in step S111 using the SOH change amount calculation unit 120.

Step S113 is a step where it is determined whether to correct the CO₂ emission amount Ea calculated in step S112. In step S113, it is determined to correct the CO₂ emission amount Ea when the SOH_Sa is corrected in the above-described step S105, and it is determined not to correct the CO₂ emission amount Ea when the SOH_Sa is not corrected. When it is determined to correct the CO₂ emission amount Ea in step S113 (in the case of "Yes" in step S113), the process proceeds to step S115 via step S114. On the other hand, when it is determined not to correct the CO₂ emission amount Ea in step S113 (in the case of "No" in step S113), step S114 is skipped and the process proceeds directly to step S115.

Step S114 is a step where the CO₂ emission amount Ea is corrected by the CO₂ emission correction unit 122 using the SOH_Sb calculated in step S105. According to step S114, the CO₂ emission amount Ea is recalculated and updated to the CO₂ emission amount Eb. Step S115 is a step where the total emission amount Ec is calculated by the CO₂ emission summation unit 123 for either the CO₂ emission amount Ea or the CO₂ emission amount Eb. According to step S115, multiple CO₂ emission amounts Ea and multiple CO₂ emission amounts may be appropriately summed according to the specified period units or notification units. Step S116 is a step where the above-described CO₂ emission information output by the CO₂ emission information output unit 124 is displayed by the CO₂ emission information display unit 125. According to step 116, the CO₂ emission information (at least one of the CO₂ emission amount Ea, the CO₂ emission amount Eb, and the total emission amount Ec) may be displayed on the CO₂ emission information display unit 125 to notify the user.

It is preferable that the CO₂ emission information be calculated using both the battery monitoring data X and the battery performance data Y of the battery 2. Alternatively, the CO₂ emission amount may be calculated using only one of the battery monitoring data X or the battery performance data Y.

### 6. Display Content on the Display Device 14

It is preferable that the display device 14, as necessary, displays the above-described SOH information linked with the CO₂ emission information together with the CO₂ emission information. For example, the CO₂ emission amount Eb and the SOH change amount Sc linked to this CO₂ emission amount Eb are displayed together. This allows the user to visually recognize the correlation between the degree of degradation of the battery 2 and the CO₂ emission amount. Additionally, based on the SOH information, the display format for the CO₂ emission information may be determined.

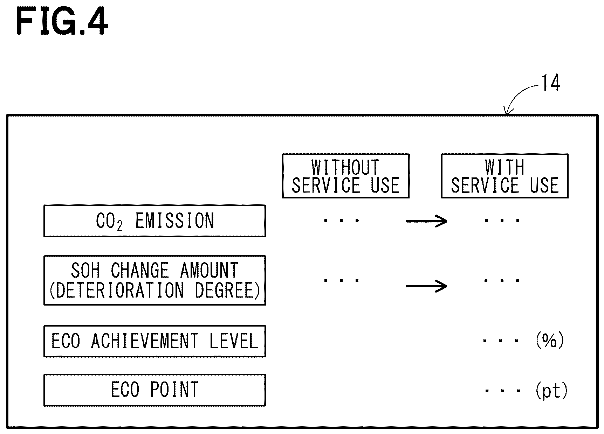

Preferably, as shown in the example of the display contents in FIG. 4, the CO₂ emission amount per unit period and the SOH change amount (degree of degradation) are compared based on usage of service and displayed on the display device 14. Additionally, in addition to this information, an effect of using the service may be displayed on the display device 14 as an eco-achievement rate (%) and an eco-point (pt) based on reduction in CO₂ emission. This allows the user to perceive the impact of reducing CO₂ emission through the use of the service in a numerical value. The "service" referred to here typically means a service provided to the user to mitigate the degradation of the battery 2 (for example, an effective charging program or a maintenance program to reduce the degradation of the battery 2).

Furthermore, instead of showing the impact of utilizing the service, an effect based on a user's own vehicle driving condition may be displayed on the display device 14. In this case, for example, in FIG. 4, "Without Service Use" may be changed to "Battery-Friendly Driving Not Practiced," and "With Service Use" may be changed to "Battery-Friendly Driving Practiced." The "battery-friendly driving" referred to here means driving performed by the user to mitigate the degradation of the battery 2. As a result, the user may quantitatively appreciate the effect of reducing CO₂ emission through the practice of battery-friendly driving.

Furthermore, detailed information about CO₂ emission (for example, a proportion of CO₂ emission at each stage, such as the manufacturing, the use, the repair, and the replacement of the battery 2) may also be additionally displayed on the display device 14.

According to the first embodiment, the following operational effects are achieved.

In the first embodiment, the CO₂ emission related to the battery 2 is calculated using the SOH information derived from the battery monitoring data X of the battery 2. Therefore, the CO₂ emission may be calculated by reflecting the actual information of the battery 2. Consequently, compared to the case where the CO₂ emission is calculated using fixed data, the CO₂ emission related to the battery 2 may be determined with higher accuracy.

Furthermore, when the SOH calculated based on the battery monitoring data X is corrected using the SOH calculated based on the battery performance data Y, it is possible to acquire the SOH more accurately.

As follows, other embodiments related to the above-described first embodiment will be described with reference to the drawings. In the other embodiments, the same reference numerals are assigned to elements identical to those in the above-described first embodiment, and descriptions of these identical elements are omitted.

### (Second Embodiment)

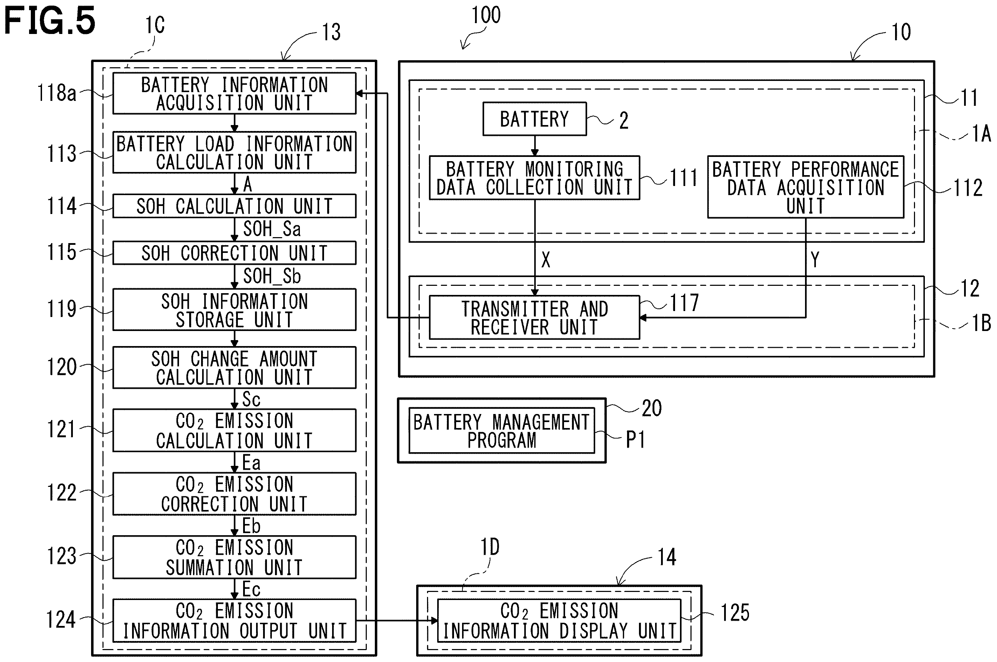

As shown in FIG. 5, the battery management system 100 of the second embodiment differs from that of the first embodiment in the configuration of the battery management unit 11 and the battery management server 13.

The battery management unit 11 of the second embodiment has only the battery monitoring data collection unit 111 and the battery performance data acquisition unit 112. That is, the battery management unit 11 of this embodiment only implements the sensing function for the battery monitoring data X and the battery performance data Y. In addition, in the battery management server 13 of the battery management system 200, compared to the first embodiment, the battery load information calculation unit 113, the SOH calculation unit 114, and the SOH correction unit 115 are moved from the battery management unit 11. Furthermore, instead of the SOH information acquisition unit 118, a battery information acquisition unit 118a is provided. The battery information acquisition unit 118a has a function of acquiring the battery information (the battery monitoring data X and the battery performance data Y) transmitted from the transmitter and receiver unit 117.

The other configurations are the same as those in the first embodiment.

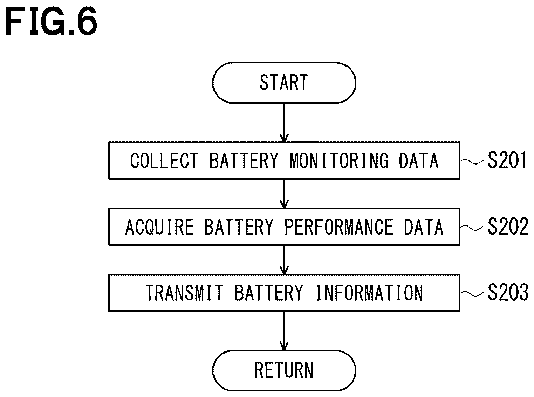

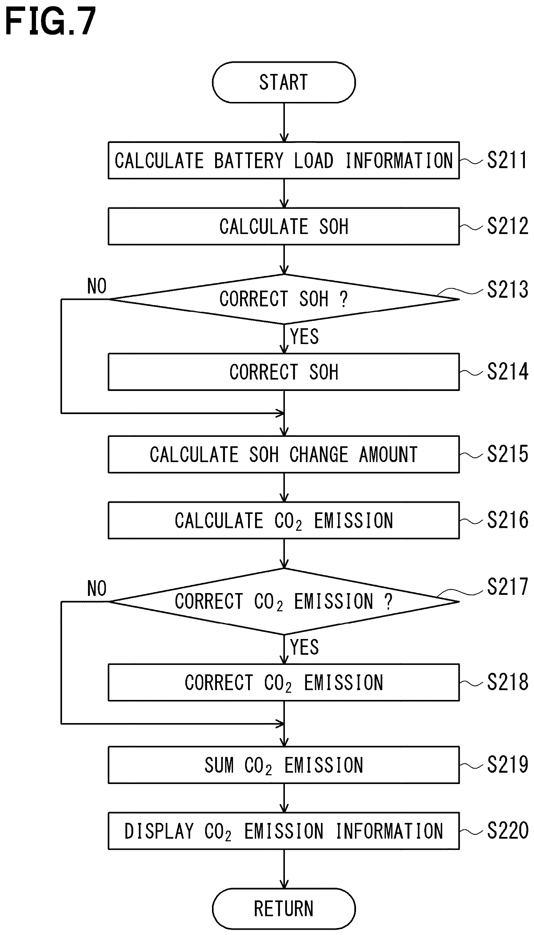

Next, the control by the battery management system 100 of the second embodiment will be described with reference to FIGS. 5 to 7. FIG. 6 shows a control flowchart in the battery management unit 11, and FIG. 7 shows a control flowchart in the battery management server 13.

As shown in FIG. 5, in the battery management unit 11 of this embodiment (see FIG. 5), steps from step S201 to step S203 are sequentially executed. It should be noted that one or more steps may be added to these steps as necessary, or multiple steps may be appropriately integrated.

Step S201 is a step of collecting the above-described battery monitoring data X by the battery monitoring data collection unit 111, similar to step S101 of the first embodiment (see FIG. 2). Step S202 is a step of acquiring the above-described battery performance data Y by the battery performance data acquisition unit 112. Step S203 is a step of transmitting the battery monitoring data X collected in step S201 and the battery performance data Y acquired in step S202 to the battery information acquisition unit 118a via the transmitter and receiver unit 117. At this time, the battery monitoring data X and the battery performance data Y may be transmitted independently or may be transmitted collectively.

As shown in FIG. 6, in the battery management server 13 of this embodiment (see FIG. 5), steps from step S211 to step S220 are sequentially executed. It should be noted that one or more steps may be added to these steps as necessary, or multiple steps may be appropriately integrated.

Steps S211 to S214 are similar to steps S102 to S105 of the first embodiment (see FIG. 2), and step S215 is similar to step S111 of the first embodiment (see FIG. 3). Additionally, steps S216 to S220 are similar to steps S112 to S116 of the first embodiment (see FIG. 3).

### (Third Embodiment)

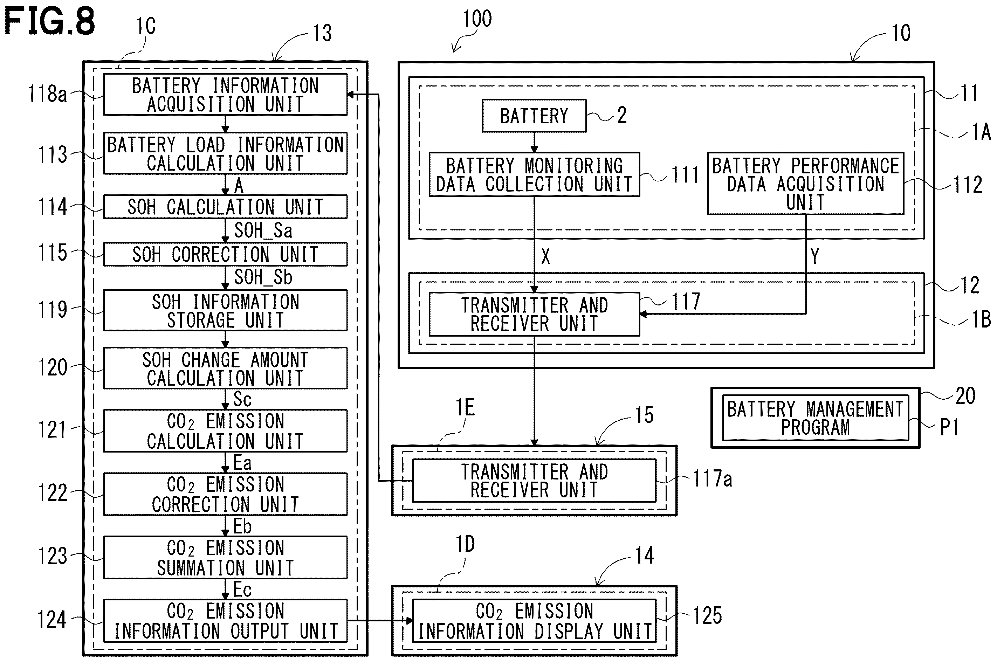

As shown in FIG. 8, the battery management system 100 of the third embodiment differs from that of the second embodiment in a battery charging stand 15 as further included. The battery charging stand 15 is equipped with a transmitter and receiver unit 117a, which is similar to the transmitter and receiver unit 117 of the in-vehicle communication device 12. This transmitter and receiver unit 117a functions to receive the battery information from the transmitter and receiver unit 117 of the in-vehicle communication device 12 and transmit this battery information to the battery information acquisition unit 118a of the battery management server 13. That is, the transmitter and receiver unit 117a is configured to relay the battery information transmitted from the in-vehicle communication device 12 to the battery management server 13. The function of this transmitter and receiver unit 117a is executed by a fifth processor 1E installed in the battery charging stand 15. This fifth processor 1E is included in the processor 1.

It should be noted that the battery charging stand 15 may also perform a part of the functions of the battery management unit 11, the in-vehicle communication device 12, the battery management server 13, and the display device 14. Additionally, the device or the equipment provided with the transmitter and receiver unit 117a may be an apparatus other than the battery charging stand 15. For example, instead of or in addition to the battery charging stand 15, the transmitter and receiver unit 117a may be provided in a battery exchange station or a battery service center.

Other configurations and controls are the same as those in the second embodiment.

According to the third embodiment, the battery information calculated by the battery management unit 11 may be transmitted to the battery management server 13 via the battery charging stand 15.

The present disclosure has been described as in the embodiments described above, nevertheless it is understood that the present disclosure is not limited to these embodiments or structures. The present disclosure also encompasses various modifications and variations within the scope of equivalents. In addition, various combinations and configurations, as well as other combinations and configurations that include only one element, more, or less, are also within the scope and spirit of the present disclosure. For example, the following embodiments, which apply the above-described embodiments, may also be implemented.

In the above embodiments, the configuration of calculating the CO₂ emission, which is one of the environmental impact factors, has been illustrated, however alternatively or additionally, emission of another environmental impact factor different from CO₂ may be calculated. Examples of "another environmental impact factor" include greenhouse gas (GHG) such as methane, nitrous oxide, substitute fluorocarbons (hydrofluorocarbons, perfluorocarbons, sulfur hexafluoride, nitrogen trifluoride, and the like), atmospheric pollutant such as SOx (sulfur oxides) and NOx (nitrogen oxides), and another resource consumption impact.

### <Display Program>

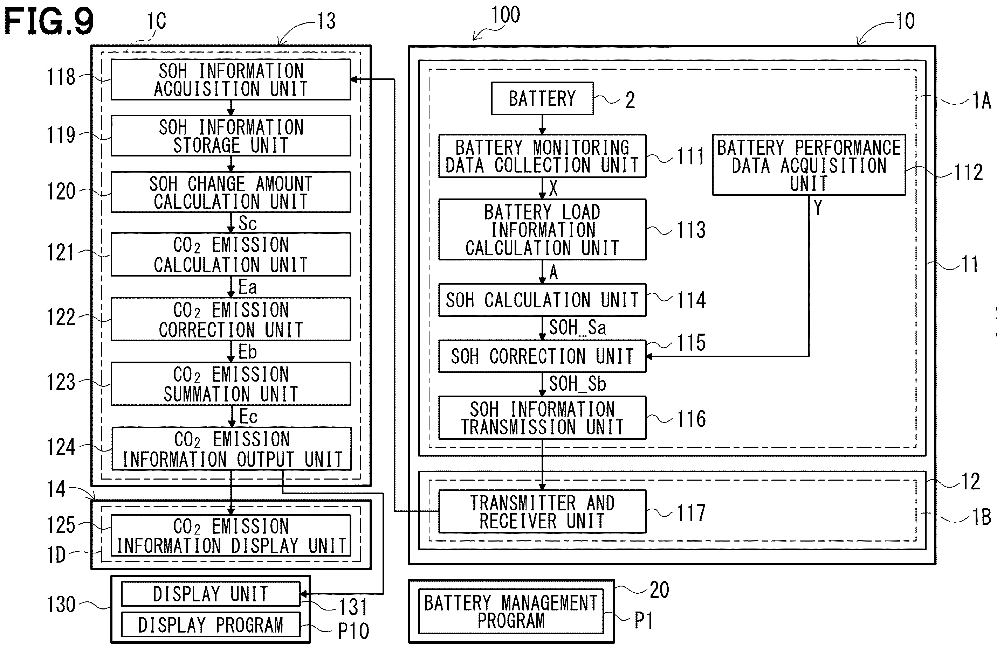

It should be noted that the battery management program P1 of the above embodiments includes at least a part of a display program P10 (see FIG. 9) described as a technical concept below. Alternatively, the display program P10 may not be included in the battery management program P1 of the above embodiments and may be provided separately. For convenience, the display program P10 has been described independently from the battery management program P1 in the drawings. This display program P10 is stored in the non-transitory storage medium 20 of at least one the battery management unit 11, the battery management server 13, the display device 14, and the battery charging stand 15. The display program P10 performs information display for the user on at least one of the CO₂ emission information display unit 125 of the display device 14 and another display unit provided separately from the CO₂ emission information display unit 125 of the display device 14.

Additionally, the display program P10 may be downloaded from a cloud server or the like to a user's device 130, such as a desktop or laptop personal computer (PC), a tablet terminal, or a mobile terminal. Furthermore, the display program P10 may perform information display for the user on the screen of the user's device 130. In such a configuration, for example, a display unit 131 shown in FIG. 9 corresponds to the screen of the user's device 130. The display program P10 may also be stored in a cloud server.

### [Technical Concept 1]

A display program (P10) is configured to cause a processor (1) to implement a function to display SOH information (S) of a battery (2) and information about an emission amount (Ea) of an environmental load factor related to the battery on a display unit (131).

### [Technical Concept 2]

The display program according to the technical concept 1, in which the display program is configured to cause the processor to implement a function to determine a display mode of the information about the emission amount (Ea) on the display unit.

## Claims

1. A battery management program (P1) configured to cause a processor (1) to implement:
a function of acquiring SOH information (S) based on battery monitoring data (X) of a battery (2); and
a function of calculating an emission amount (Ea) of an environmental load factor related to the battery based on the SOH information as acquired.

2. The battery management program according to claim 1, wherein
the battery management program is configured to cause the processor (1) to implement a function of calculating the emission amount based on an SOH change amount (Sc) of an SOH of the battery per unit period based on the SOH information and an emission factor of the environmental load factor.

3. The battery management program according to claim 1 or 2, wherein
the battery management program is configured to cause the processor (1) to implement:
a function of calculating the SOH (SOH_Sa) of the battery based on battery load information (A) acquired from the battery monitoring data;
a function of correcting the SOH as calculated based on battery performance data (Y) of the battery; and
a function of acquiring, as the SOH information, the SOH (SOH_Sb) as corrected.

4. The battery management program according to claim 1 or 2, wherein
the battery management program is configured to cause the processor (1) to implement a function of summing the emission amount based on at least one of a period unit and a notification unit.

5. A battery management system (100) comprising:
an SOH information acquisition unit (13) configured to acquire SOH information (S) based on battery monitoring data (X) of a battery (2);
an emission calculation unit (121) configured to calculate an emission amount (Ea) of an environmental load factor related to the battery based on the SOH information acquired by the SOH information acquisition unit; and
a display unit (125) configured to display environmental load factor emission amount information related to the emission amount calculated by the emission calculation unit.

6. The battery management system according to claim 5, further comprising:
an SOH change amount calculation unit (120) configured to calculate an SOH change amount (Sc) of the battery per unit period based on the SOH information, wherein
the emission calculation unit is configured to calculate the emission amount based on the SOH change amount calculated by the SOH change amount calculation unit and an emission coefficient of the environmental load factor.

7. The battery management system according to claim 5 or 6, further comprising:
an SOH calculation unit (114) configured to calculate an SOH (SOH_Sa) of the battery based on battery load information (A) acquired from the battery monitoring data; and
an SOH correction unit (115) configured to correct the SOH calculated by the SOH calculation unit based on battery performance data (Y) of the battery, wherein
the SOH information acquisition unit is configured to acquire, as the SOH information, the SOH (SOH_Sb) corrected by the SOH correction unit.

8. The battery management system according to claim 5 or 6, further comprising: an emission summation unit (123) configured to sum the emission amount calculated by the emission calculation unit based on at least one of a period unit and a report unit.
